# EUROPÄISCHE PATENTSCHRIFT

(11) **EP 0 913 348 B1**
(45) Veröffentlichungstag und Bekanntmachung des Hinweises auf die Patenterteilung: **10.12.2003**
(21) Anmeldenummer: 98119370.9
(22) Anmeldetag: 14.10.1998
(51) Int. Cl.: B65G 39/04, B65G 13/00, H05K 13/00

(54) **Taumelscheiben-Transportsystem**
Swash plate transport system
Système de transport à plateaux en biais

(30) Priorität: 01.11.1997 DE 19748337
(43) Veröffentlichungstag der Anmeldung: 06.05.1999
(73) Patentinhaber: Gebr. Schmid GmbH & Co., D-72250 Freudenstadt (DE)
(72) Erfinder: Schmid, Dieter C. Dipl.-Ing., 72250 Freudenstadt-Dietersweiler (DE)
(74) Vertreter: Patentanwälte Ruff, Wilhelm, Beier, Dauster & Partner

(56) Entgegenhaltungen:
- DE-B- 1 145 092
- DE-B- 1 192 883
- DE-U- 8 524 053
- FR-A- 2 637 875
- US-A- 5 553 700

## Beschreibung

Die Erfindung betrifft eine Leiterplatten-Transportvorrichtung.

Leiterplatten-Transportvorrichtungen werden insbesondere zum Transport von Leiterplatten verwendet, die mittels einer Behandlungsvorrichtung zu behandeln sind. Eine gattungsgemäße Leiterplatten-Transportvorrichtung hat mindestens eine um eine Wellenachse drehbare Transportwelle, die zum Transport der Leiterplatte in einer Transportrichtung vorgesehen ist. Der Transportwelle sind quer zur Wellenachse abstehende Transportorgane mit radial außenliegenden, in Abrollkontakt mit der Leiterplatte bringbaren Transportbereichen zugeordnet, die beim Transport eine normalerweise im wesentlichen ebene Oberfläche der Leiterplatte entlang von insbesondere streifenförmigen Kontaktbereichen kontaktieren.

Derartige Leiterplatten-Transportvorrichtungen werden beispielsweise in Behandlungsvorrichtungen eingesetzt, in denen eine oder beide Leiterplattenoberflächen mit einem oder mehreren meist flüssigen Behandlungsmedien behandelt werden. So werden beispielsweise Leiterplatten, die auf oder zwischen Transportrollen horizontal geführt werden, häufig von oben und/oder unten mit Behandlungsflüssigkeiten, z.B. Säuren oder flüssigen Lösungen behandelt. Sie können beispielsweise besprüht und/oder bestrahlt werden. Eine Leiterplatte kann auch durch ein ggf. mit Schwalldüsen ausgerüstetes Behandlungsbad geführt werden. Zur Behandlung kann die Behandlungsvorrichtung eine oder mehrere Behandlungsstationen aufweisen. Eine Leiterplatten-Transportvorrichtung kann sowohl zum Transport einer Leiterplatte innerhalb einer Behandlungsstation, als auch zum Transport zwischen Behandlungsstationen verwendet werden.

Innerhalb einer Behandlungsstation soll eine zu behandelnde Oberfläche für das Behandlungsmedium möglichst frei zugänglich sein. Meist ist es auch erwünscht, daß das Behandlungsmedium wieder zügig von der behandelten Oberfläche wegbewegt werden kann, damit das Behandlungsmedium nicht unkontrollierbar lange mit der beispielsweise zu ätzenden oder zu reinigenden Oberfläche in Kontakt bleibt. Außerdem sollen die Transportorgane die Oberfläche des zu transportierenden Gegenstandes nicht oder nur geringfügig mechanisch belasten oder gar beschädigen.

Bei bisher bekannten Ausführungen des Standes der Technik mit auf den Transportwellen angeordneten Rollen behindern diese den Zugang und das Abfließen der Behandlungsflüssigkeit. Die meist sehr dicht angeordneten Transportmittel schirmen nämlich nicht nur einen beträchtlichen Teil der zu behandelnden Oberflächen der Leiterplatte nach oben bzw. unten ab, sondern können darüberhinaus ein Abfließen der Behandlungsflüssigkeit quer zur Transportrichtung verhindern. Es kann zur Ausbildung sogenannter "Längskanäle" mit gestautem, wenig bewegtem Behandlungsmedium kommen. Transportrollen können außerdem auf den Oberflächen in Transportrichtung verlaufende streifenförmige Kontaktbereiche hinterlassen, die von den Behandlungsmedium schlechter als die umgebenden Bereiche erreicht wurden. Zur Verminderung oder Vermeidung dieser Probleme ist in der Europäischen Patentanmeldung EP 0 750 455 schon eine Transportvorrichtung für Leiterplatten vorgeschlagen worden, bei der die Transportbereiche wendelförmig bzw. schraubenförmig oder schneckenartig um die Transportwelle herumvertaufen. Diese Ausführungsform fördert insbesondere das seitliche Abfließen von Behandlungsmedium, da sie nach Art einer Förderschnecke mit einer Förderrichtung senkrecht zur Transportrichtung wirkt. Aus der gleichen Patentanmeldung sind auch Transportwellen bekannt, deren Transportorgane von längs der Transportwelle angeordneten Rollenabschnitten in Form von Kreissegmenten gebildet sind. Solche Ausführungsformen mit über den Umfang der Transportorgane unterbrochenen Transportbereichen sollen eine gute Zugänglichkeit der Leiterplatten von oben und/oder unten für das Behandlungsmedium und gleichzeitig ein gutes seitliches Abströmen des Behandlungsmediums gewährleisten.

Während Transportwellen mit wendelförmigen Transportbereichen nachteilig sein können, wenn ein seitlicher Transport des Behandlungsmediums unerwünscht ist, können die in Umfangsrichtung unterbrochenen Rollen beim Transport zu einer stoßweisen mechanischen Belastung des transportierten Gegenstandes führen, was insbesondere bei mechanisch wenig belastbaren Leiterplatten und/oder solchen mit empfindlichen Oberflächen nachteilig sein kann.

Die US 5 553 700 A beschreibt ein Transportsystem für Leiterplatten innerhalb von Behandlungssystemen, bei dem die Leiterplatten auf einer horizontalen Transportebene zwischen Transportorganen geführt sind. Diese sind auf einer jeweils auf einer Welle aufgereihte Draht- oder Speichenrädergebilde, die eine gewellte Ablaufbahn auf der Leiterplatte erzeugen. Diese Transportorgane sind in horizontaler Richtung relativ weit voneinander entfernt angeordnet.

Bei Tragrollenanordnungen für Förderbänder nach der DE 1 145 092 B sind Transportorgane nach Art von Taumelscheiben ausgebildet und in einzelnen Segmenten hintereinander auf einer Antriebswelle aufgereiht. Es soll damit eine verbesserte Führung der Förderbänder erreicht werden.

In der FR 2 637 875 A ist ein Transportsystem für besonders heiße Gegenstände beschrieben worden, bei dem einander überlappende zahnradartig geformte Scheiben als Transportorgane eingesetzt sind. Diese sollen durch verringerte Kontaktflächen die Wärmeübertragung in das Transportsystem hinein verringern.

Die Erfindung stellt sich die Aufgabe, eine insbesondere zum Transport von Leiterplatten in Leiterplatten-Behandlungsvorrichtungen verwendbare Leiterplatten-Transportvorrichtung zu schaffen, die die genannten Nachteile des Standes der Technik vermeidet. Insbesondere soll eine möglichst gleichmäßige Behandlung von Leiterplattenoberflächen bei geringer mechanischer Belastung der Leiterplatte ermöglicht werden.

Zur Lösung dieser Aufgabe schlägt die Erfindung eine Leiterplatten-Transportvorrichtung mit den Merkmalen von Anspruch 1 vor.

Dadurch, dass die Transportwellen einer Transportwellengruppe derart zueinander angeordnet sind, dass eine maximale radiale Ausdehnung der Transportorgane größer ist als der halbe Abstand in Transportrichtung aufeinanderfolgender Transportwellen zueinander, entsteht in Transportrichtung gesehen, ein Ineinanderkämmen bzw. gegenseitiges Überlappen der Transportorgane. Dadurch können die Berührungsbereiche zwischen Transportorgan und Leiterplatte relativ nahe zueinander angeordnet werden. Dies ist vorteilhaft, weil dadurch ein Umknicken oder ein Verhaken der Leiterplatten zwischen aufeinanderfolgenden benachbarten Transportwellen zuverlässig verhindert werden kann. Dies ist unter anderem deshalb von großer Bedeutung, da die zu transportierenden Leiterplatten immer dünner werden (z.B. bis zu Dicken von nur ca. 25 µm) und dementsprechend aufgrund ihrer Biegsamkeit sehr empfindlich sind.

Bei derartigen, wie bei allen anderen Ausführungsformen der Erfindung können die Transportorgane von in Transportrichtung aufeinanderfolgenden Transportwegen quer zur Transportrichtung gegeneinander versetzt sein. Dadurch kann insbesondere das Ineinanderkämmen von im wesentlichen identisch mit Transportorganen bestückten Transportwellen ermöglicht werden. Bei einer bevorzugten Ausführungsform hat eine zweite auf eine Transportwelle folgende Transportwelle eine identische Anordnung von Transportorganen. Die dazwischenliegende Transportwelle einer Gruppe von drei Transportwellen ist quer versetzt, vorzugsweise um einen Betrag, der dem halben axialen Abstand benachbarter Transportorgane einer Transportwelle entspricht. Bevorzugt ist es, wenn die Transportbereiche von in Transportrichtung aufeinanderfolgenden, gegeneinander versetzten Transportwellen gleichphasig oszillieren. Es ist jedoch auch möglich und kann vorteilhaft sein, wenn beispielsweise in einer Gruppe von drei aufeinanderfolgenden Transportwellen die Transportorgane bzw. Transportbereiche der mittleren Transportwelle gegenläufig, insbesondere um 180° phasenversetzt oszillieren.

Die Leiterplatten-Transportvorrichtung ist derart ausgebildet, daß die an den Transportorganen vorgesehenen Transportbereiche während der Drehung der Transportwellen quer zur Transportrichtung oszillieren bzw. sich in dieser Querrichtung hin- und herbewegen. Die Richtung der Oszillationsbewegung verläuft dabei parallel zur Wellenachse. Durch die Oszillationsbewegung kann das Behandlungsmedium im Bereich der Transportorgane geringfügig hin- und herbewegt werden, was die Effektivität und Gleichmäßigkeit der Behandlung fördern kann. Die Bewegung der Behandlungsflüssigkeit erfolgt allerdings nur in der Größenordnung der Schwankungsbreite der Transportbereiche. Dies kann eine Durchmischung von teilweise verbrauchtem und frischem Behandlungsmedium fördern und damit zu einer effektiveren und gleichmäßigeren Behandlung führen. Gleichzeitig wird eine makroskopische Förderung von Behandlungsmedium in Querrichtung, wie sie bei wendelförmigen Transportorganen auftreten kann, vermieden.

Die Oszillationsbewegung verläuft sinusförmig.

Die Transportwellen sind in ihrer Axialrichtung im wesentlichen unbeweglich gelagert, während die Transportorgane als elliptische Scheiben oder Ringe ausgebildet sind, die in einem Schrägungswinkel zur Radialrichtung der Wellenachse stehen, der derart gewählt ist, daß die Projektion eines Transportorganes in Richtung der Wellenachse im wesentlichen kreisförmig ist. Eine große Halbachse der elliptischen Form eines Transportorganes hat in diesem Fall eine Länge, die im wesentlichen dem Quotienten aus dem Radius des Transportorganes, gesehen in Axialrichtung, und dem Cosinus des Schrägungswinkels entspricht. Die Länge der kleinen Halbachse entspricht dem Radius. Derart gestaltete Transportorgane werden im folgenden auch als Taumelscheiben bezeichnet, weil sie bei Drehung der Transportwelle, in Transportrichtung betrachtet, in Querrichtung hin- und herzutaumeln bzw. zu pendeln scheinen. Eine Auf- und Ab-Bewegung senkrecht zur Transportebene findet praktisch nicht statt.

Durch die Anbringung derartiger leicht herzustellender, taumelscheibenartiger Transportorgane auch an bereits existierenden Transportvorrichtungen können diese auf einfache Weise in erfindungsgemäß arbeitende Transportvorrichtungen umgerüstet werden.

Die Schwankungsbreite der Transportbereiche ist derart, daß sie Schwankungsbreiten von üblichen, mit Fertigungstoleranzen behafteten Rollen oder dergleichen deutlich übersteigt. Bei einer bevorzugten Ausführungsform ist die Transportvorrichtung derart ausgebildet, daß eine in Querrichtung gemessene Schwankungsbreite der Transportbereiche die Breite der Transportbereiche in Querrichtung übersteigt. Dies hat zur Folge, daß die Kontaktbereiche an der Plattenoberfläche, also die Bereiche, an denen die Transportbereiche an der Plattenoberfläche angreifen, in Transportrichtung gesehen unterbrochen sind. Bei Ausführungsformen, in denen die Transportorgane als Taumelscheiben ausgebildet sind, kann der Schrägungswinkel der Breite der Transportbereiche und den radialen Abmessungen der Transportorgane derart angepaßt sein; daß die Schwankungsbreite größer als die Transportbereich-Breite ist. Beispielsweise kann der Schrägungswinkel zwischen 10 und 20° liegen, insbesondere bei 15°. Das Verhältnis von Querrichtungsbreite eines Transportbereiches zum Radius des Transportorganes, gesehen in Axialrichtung, kann zwischen 0,2 und 0,5 liegen, vorzugsweise bei etwa 0,3. Derart ausgelegte Transportorgane zeichnen sich durch hinreichende Schwankung in Querrichtung bei gleichzeitig großer Laufruhe aus.

Es ist möglich, die Transportorgane derart auszubilden, daß deren Transportbereiche in Wellenachsenrichtung in Richtung auf die zu transportierende Platten beispielsweise konvex gekrümmt sind. Derartige Transportorgane kontaktieren die Plattenoberflächen im wesentlichen entlang linienförmiger Kontaktbereiche. Bei einer bevorzugten Ausführungsform haben die Transportorgane einachsig gekrümmte Transportbereiche, die im wesentlichen vollständig auf einer koaxial zur Wellenachse liegenden Kreiszylinder-Mantelfläche liegen. Dies ergibt während des Abrollens zwischen Transportorgan und Plattenoberfläche Berührungslinien endlicher Länge, die parallel zur Wellenachse verlaufen, und die Kontaktbereiche an der Plattenoberfläche haben eine endliche Ausdehnung in Querrichtung, sind also streifenförmig. Dies vermindert und vergleichmäßigt unter anderem den Kontaktdruck zwischen Transportorgan und Leiterplatte.

Obwohl die Breite der Transportbereiche in Umfangsrichtung variieren kann, haben bei einer bevorzugten Ausführungsform die Transportbereiche mindestens abschnittsweise, vorzugsweise um den gesamten Umfang eines Transportorganes eine im wesentlichen konstante Breite, wodurch ein Kontaktbereich bzw. eine Abwälzung des Transportorganes auf der Plattenoberfläche entsteht, die in Querrichtung eine konstante Breite hat. Eine im wesentlichen konstante Kontaktbreite bewirkt beispielsweise bei auf Transportorganen mit einer gegebenen Auflagekraft aufliegenden Platten, daß der Kontaktdruck entlang des gesamten Umfanges eines Transportorganes im wesentlichen konstant bleibt, wodurch eine gleichmäßige mechanische Belastung der Plattenoberfläche gewährleistet ist.

Ein gleichmäßiger Kontaktdruck zwischen Transportorgan und Leiterplatte kann auch dadurch gefördert werden, daß die Transportbereiche der Transportorgane in Umfangsrichtung ununterbrochen sind, so daß während der Drehung der Transportwelle ein Transportorgan ständig in Berührungskontakt mit der transportierten Platte ist. Es ist aber auch möglich, Transportorgane mit über ihren Umfang unterbrochenen Transportbereichen zu verwenden, was sowohl eine gute Zugänglichkeit der Leiterplattenoberfläche von oben und/oder unten für das Behandlungsmedium als auch ein gutes seitliches Abströmen des Behandlungsmediums gewährleisten kann. Ein gutes seitliches Abströmen bei gleichzeitig schonendem, im wesentlichen konstanten Kontaktdruck zwischen Transportorgan und Plattenoberfläche kann beispietsweise auch dadurch erreicht werden, daß ein Transportorgan die Form einer ansonsten durchgehenden Scheibe mit in Axialrichtungen durchgehenden Durchbrechungen hat, beispielsweise nach Art einer Autofelge.

Eine oder jede Transportwelle der Transportvorrichtung kann ein einzelnes Transportorgan haben, jedoch ist es bevorzugt, wenn eine Transportwelle mehrere in vorzugsweise gleichen axialen Abständen versetzt zueinander angeordnete Transportorgane aufweist. Diese können vorzugsweise gleichphasig oszillieren, was bei den taumelscheibenartigen Transportorganen dadurch erreicht werden kann, daß die planparallelen, ebenen Scheiben jeweils identische elliptische Dimensionen haben und ihre Ebenen parallel zueinander verlaufen.

Üblicherweise hat eine Plattentransportvorrichtung mehrere in Transportrichtung hintereinander angeordnete Transportwellen mit vorzugsweise parallelen Wellenachsen, deren Transportorgane derart angeordnet sind, daß ihre Transportbereiche eine Transportebene für die Leiterplatte tangieren bzw. bilden. Bei horizontal transportierten Leiterplatten bilden die Transportorgane der unterhalb der Leiterplatte angeordneten Transportwellen Auflageelemente, die die Leiterplatte abstützen und transportieren. Die in Transportrichtung hintereinander angeordneten Transportwellen bilden eine Transportwellengruppe.

Bei einer Weiterbildung der Erfindung sind die Transportwellen derart ausgebildet und/oder angeordnet, daß die Leiterplatte kontaktierende Transportbereiche paarweise gegenläufig, insbesondere um 180° phasenversetzt oszillieren. Dadurch ist eine mindestens teilweise, vorzugsweise vollständige Kompensation von auf die Leiterplatte wirkenden Querkräften möglich, wodurch ein richtungsgenauer Transport der Leiterplatte in Transportrichtung gewährleistet werden kann. Die Kompensation von Querkräften kann beispielsweise innerhalb einer Transportwelle und/oder zwischen in Transportrichtung aufeinanderfolgenden Transportwellen erfolgen.

Bei einer bevorzugten Ausführungsform ist einer zur Kontaktierung einer Plattenoberfläche der Leiterplatte vorgesehenen Transportwelle mindestens eine zur Kontaktierung der gegenüberliegenden Plattenoberfläche vorgesehene Transportwelle zugeordnet. Insbesondere können zwei quer, insbesondere senkrecht zu einer Transportebene versetzt angeordnete, vorzugsweise in ihrem senkrechten Abstand einstellbare Transportwellengruppe vorgesehen sein, die von gegenüberliegenden Seiten an die Leiterplatte angreifen können. Vorzugsweise sind einander gegenüberliegende Transportwellen derart ausgebildet und angeordnet, daß deren Transportbereiche gegenläufig, insbesondere um 180° phasenversetzt oszillieren.

Bei einer Weiterbildung der Erfindung sind die Transportorgane einer Transportwelle an separaten Bauelementen angeordnet, die längs der Transportwelle aneinandergereiht sind. Die Bauelemente können insbesondere nabenförmig sein und vorzugsweise einander berührend auf einen Wellenkern aufgesteckt sein. Ein Bauelement kann mehrere Transportorgane aufweisen, jedoch weist vorzugsweise jedes Bauelement ein einziges Transportorgan, insbesondere eine Taumelscheibe, auf. Üblicherweise sind eine Vielzahl baugleicher Bauelemente zum Zusammenbau einer Transportwelle vorgesehen. Die Transportwelle kann durch die Bauelemente selbst gebildet sein, wenn diese im Verbund die erforderliche Stabilität für die Verwendung als Transportwelle besitzen. Beispielsweise können die Bauelemente oder Module aneinandergeklebt oder aneinandergeschweißt sein. Bei auf einen gesonderten Wellenkern aufgesteckten, nabenförmigen Bauelementen können diese relativ zum Wellenkern drehbar sein, sind jedoch vorzugsweise auf diesem beispielsweise durch Verkleben, Verklemmen, Anschweißen oder dergleichen drehfest befestigt.

Vorzugsweise sind an den Bauelementen insbesondere stirnseitige Eingriffsmittel für eine drehfeste Verbindung benachbarter Bauelemente vorgesehen, die insbesondere Vorsprünge und/oder Ausnehmungen zum formschlüssigen Eingriff der Bauelemente ineinander umfassen. Vorzugsweise sind die Eingriffsmittel für die Anordnung der Transportorgane mit definierter Orientierung zueinander entlang der Transportwelle ausgebildet, so daß sie nur in einer gewünschten relativen Orientierung zueinander verwendet werden können. Die Eingriffsmittel können beispielsweise nach Art von Hirth-Verzahnungen ausgeführt sein. Vorzugsweise umfassen die Eingriffsmittel einen im wesentlichen halbkreisförmigen Zapfen, der mit einer entsprechenden halbkreisförmigen Ausnehmung eines benachbarten Bauelementes zusammenwirkt und nur eine einzige relative Drehorientierung benachbarter Bauelemente zuläßt.

Eine besonders wirtschaftlich herstellbare Ausführungsform zeichnet sich dadurch aus, daß alle Bauelemente einer Transportwelle, vorzugsweise alle Bauelemente der Transportvorrichtung, identisch sind. Dies ermöglicht es, Transportvorrichtungen mit einer beliebigen Anzahl kostengünstig in Großserien herstellbaren Bauelementen in modularer Weise aufzubauen.

Als Material für die Transportwelle bzw. die Transportorgane können grundsätzlich alle Materialien verwendet werden, die für die Behandlungsbedingungen der Leiterplatten geeignet sind, beispielsweise geeignete Metalle oder gegen die Behandlungsmedien beständige Kunststoffe. Für eine besonders schonende mechanische Kontaktierung der Leiterplatten ist es besonders vorteilhaft, wenn die Transportorgane mindestens im Bereich der Transportbereiche aus weichem, insbesondere gummiartigem Material bestehen. Insbesondere können die Bauelemente einstückig aus dem Material der Transportorgane gefertigt sein. Es ist auch möglich, die Transportorgane derart auszubilden, daß der Transportbereich durch Borsten nach Art einer Bürstenoberfläche gebildet wird.

Weitere Merkmale und Einzelheiten der Erfindung ergeben sich aus der nachfolgenden Beschreibung von bevorzugten Ausführungsformen in Verbindung mit den Zeichnungen und den Unteransprüchen. Hierbei können die einzelnen Merkmale jeweils für sich allein oder zu mehreren in Kombination miteinander bei einer Ausführungsform verwirklicht sein. Ausführungsbeispiele der Erfindung werden in den Zeichnungen dargestellt und im folgenden näher erläutert. In den Zeichnungen zeigen:
- Fig. 1: eine schematische Draufsicht auf drei in Transportrichtung aufeianderfolgende, in einer gemeinsamen Transportebene liegenden, ausschnittsweise dargestellte Transportwellen einer Ausführungsform einer LeiterplattenTransportvorrichtung,
- Fig. 2: eine ausschnittsweise dargestellte Transportwelle mit zwei Transportorganen und die auf einer Leiterplatte durch Abwälzung der Transportorgane sich ergebenden sinusförmigen Kontaktbereiche,
- Fig. 3: eine ausschnittsweise, schematische Ansicht einer Leiterplatten-Transportvorrichtung in Transportrichtung, bei der zwischen oberen und unteren Transportwellen eine Leiterplatte angeordnet ist, und
- Fig. 4: verschiedene Ansichten eines Bauelementes mit einem Transportorgan nach Art einer Taumelscheibe.

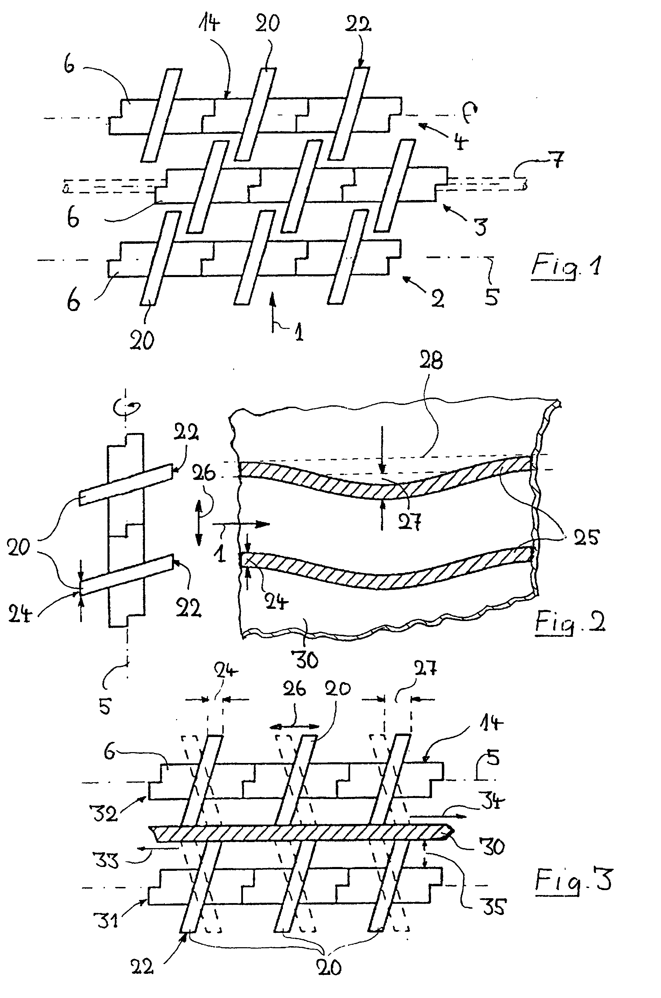

Die Draufsicht in Fig. 1 zeigt axiale Ausschnitte von drei in Transportrichtung 1 aufeinanderfolgenden, in einer gemeinsamen Ebene liegenden Transportwellen 2 bis 4 einer Ausführungsform einer erfindungsgemäßen Leiterplatten-Transportvorrichtung, die im folgenden auch kurz Transportvorrichtung genannt wird. Die Transportvorrichtung hat in der gezeigten Ebene mehrere derartiger Dreiergruppen von Transportwellen, wobei der Abstand einer Dreiergruppe zu darauffolgenden größer ist als der Abstand der Transportwellen einer Dreiergruppe untereinander. Die Transportwellen 2 bis 4 sind über endseitige Synchronisationszahnräder drehfest miteinander gekoppelt und drehen sich gleichsinnig und in gleicher Drehgeschwindigkeit um ihre Wellenachsen 5. Jede der Transportwellen ist modular aus nabenförmigen Bauelementen 6 aufgebaut, die auf einem bei der mittleren Transportwelle 3 gestrichelt angedeuteten Wellenkern 7 aufgesteckt und ohne gegenseitigen axialen Abstand zueinander aneinandergereiht sind. Die Bauelemente 6 können mit dem Wellenkern 7 beispielsweise verklemmt oder durch Verkleben an diesem befestigt sein.

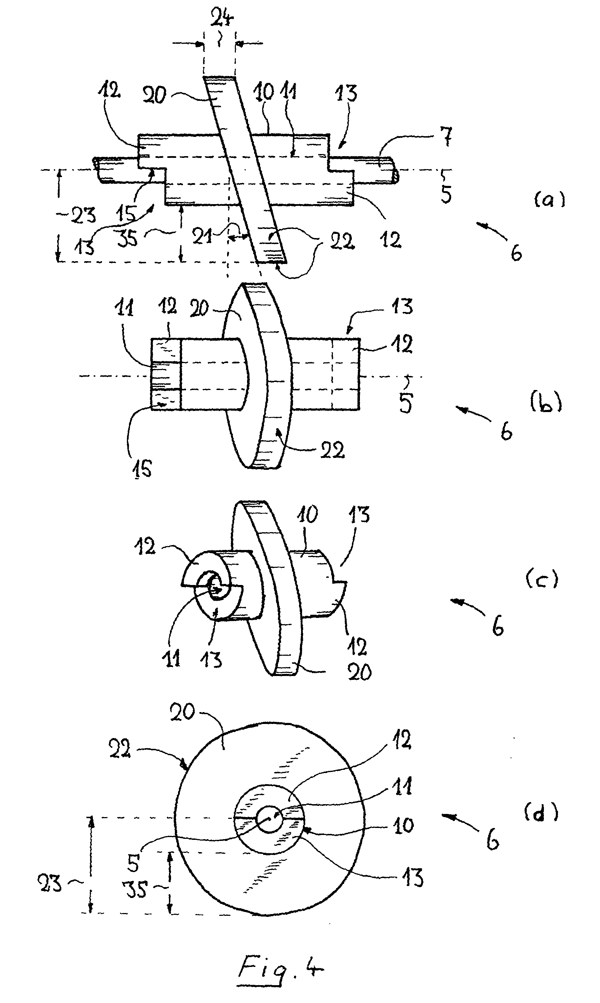

Ein Bauelement 6 der in Fig. 1 gezeigten Art ist in Fig. 4 aus verschiedenen Ansichten im Detail gezeigt. Das Bauelement 6 ist aus einem hartgummiartigen, säurebeständigen Kunststoff einstückig hergestellt und hat einen zylindrischen Körper 10 mit einer zylindrischen, koaxialen Durchgangsöffnung 11, durch die der zylindrische Wellenkern 7 spielfrei hindurchführbar ist. Die Durchgangsöffnung 11 kann geringes Untermaß aufweisen, so daß das Bauelement 6 auf dem Wellenkern 7 festklemmbar ist. Die Wellenachse 5 fällt mit der zentralen Längsachse 5 des Drehmomentes zusammen. Die axialen Stirnseiten des Körpers 10 weisen jeweils um 180° um die Achse 5 versetzt zueinander halbkreisförmige Vorsprünge 12 auf, denen diametral gegenüberliegende, halbkreisförmige Ausnehmungen 13 entsprechen. Axial benachbarte Bauelemente können, wie in den Figuren 1 bis 3 gezeigt, drehfest und in fest vorgegebener relativer Orientierung zueinander angeordnet werden, indem jeweils die benachbarten Bauelemente so gegeneinander verdreht werden, daß ein Vorsprung 12 eines Bauelementes in eine entsprechende Ausnehmung des benachbarten Bauelementes paßt. Die auf diese Weise über ihre Eingriffsmittel 12, 13 formschlüssig ineinandergreifenden Körper 10 der Bauelemente bilden, wie in den Figuren 1 bis 3 gezeigt, einen zylindrischen inneren Bereich 14 der Transportwelle.

Jedes der nabenförmigen Aufsteck-Bauelemente 6 hat ein einziges, quer zur Achse 5 abstehendes Transportorgan 20 in Form einer schräggestellten planparallelen Scheibe bzw. eines derartigen Ringes. Die Anordnung des Transportorganes am Bauelement ist in Fig. 4 gut zu erkennen. Fig. 4a zeigt eine Seitenansicht eines auf einen Wellenkern 7 aufgeschobenen nabenförmigen Bauelementes 6 in einer Richtung parallel zu den ebenen Begrenzungsflächen des scheibenförmigen Transportorgans 20. Fig. 4b zeigt das gleiche Bauelement nach einer Drehung um 90° um die Wellenachse derart, daß die der linken Ausnehmung 13 zugewandte diametrale Begrenzungsfläche 15 des Vorsprungs 12 zum Betrachter gerichtet ist. In Fig. 4c ist das Bauelement der Fig. 4a um etwa 30° um eine zur Wellenachse 5 radiale Achse gedreht, so daß die Formgebung der Eingriffsmittel 12, 13 der in Fig. 4a linken Stirnseite deutlich erkennbar ist. Fig. 4d zeigt das die elliptische Taumelscheibe aufweisende Bauelement 6 aus Fig. 4a in axialer Richtung. In dieser Axialprojektion erscheint die elliptische Taumelscheibe 20 kreisförmig.

In den Figuren 1 bis 3 und 4a ist zu erkennen, daß das auch als Taumelscheibe bezeichenbare Transportorgan 20 mit seinen axialen, planparallelen Seitenflächen in einem Schrägungswinkel 21 von ca. 15° zu einer senkrecht auf der Wellenachse 5 stehenden Ebene ausgerichtet ist. Diese Schrägstellung bewirkt, daß der in Umfangsrichtung um das Transportorgan herum verlaufende, radial außenliegende, in Abrollkontakt mit einer Leiterplatte bringbare Transportbereich 22 senkrecht zur Scheibenebene des Transportorganes betrachtet eine elliptische Form hat, parallel zur Wellenachse 5 betrachtet jedoch eine kreisrunde Form (siehe Fig. 4d). Der Transportbereich 22 liegt im wesentlichen vollständig auf einer koaxial zur Wellenachse 5 liegenden Kreiszylinder-Mantelfläche und hat einen konstanten radialen Abstand 23 von der Wellenachse. Mit anderen Worten: das Transportorgan hat die Form einer aus einer im Querschnitt runden Salami durch schräge, parallele Schnitte geschnittenen Salamischeibe.

Wie am besten in Fig. 4a zu erkennen, ist die axiale Breite 24 des Transportbereiches, also seine Breite quer zur Transportrichtung (die senkrecht zur Zeichnungsebene in Fig. 4 verläuft), im wesentlichen konstant. Dies bewirkt, wie in Fig. 2 gezeigt, daß eine Abwälzung des Transportbereiches auf einer Leiterplatte 30 einen streifenförmigen Kontaktbereich 25 mit entlang der Transportrichtung im wesentlichen konstanter Breite berührt.

In Fig. 2 ist auch zu erkennen, daß eine Abrollung einer Taumelscheibe 20 auf oder unter einer in Transportrichtung 1 transportierten Leiterplatte 30 einen Kontaktbereich 25 ergibt, der einen sinuswellenartigen Verlauf hat. Dieser wird dadurch erzeugt, daß bei einer drehenden Transportwelle sich die in Kontakt mit der Leiterplatte stehenden, linienförmigen Berührungsbereiche der Transportbereiche mit der Leiterplatte in einer Querrichtung 26 zur Transportrichtung hin- und herbewegen bzw. oszillieren.

Die in Querrichtung 26 gemessene Schwankungsbreite 27 der Transportbereiche wird bei den schräggestellten Taumelscheiben durch den radialen Abstand 23 der Transportbereiche 22 von der Drehachse 5 und durch den Schrägungswinkel 21 bestimmt und ist bei der gezeigten Ausführungsform größer als die axiale Breite 24 der Transportbereiche. Wie in Fig. 2 rechts zu erkennen, bewirkt diese Dimensionierung, daß ein oszillierender Kontaktbereich 25 in Querrichtung so stark von einem gestrichelt gezeichneten Kontaktbereich 28 einer entsprechend breiten, nicht schräggestellten Scheibe abweicht, daß der oszillierende Kontaktbereich 25 in Transportrichtung 1 betrachtet unterbrochen ist. Durch entsprechende Anordnung in Transportrichtung aufeinanderfolgender Transportwellen mit Taumelscheiben kann erreicht werden, daß sich deren Kontaktbereiche nicht vollständig überdecken, sondern gegeneinander phasenverschoben sind und sich somit ggf. nur punktuell überschneiden. Insgesamt kann eine räumlich variable Kontaktierung der transportierten Leiterplatte erreicht werden, die eine Ausbildung von unerwünschten, in Transportrichtung verlaufenden Streifen mit ggf. unzureichender Behandlung durch das Behandlungsmedium vermeiden. Die während der Drehung der Transportwellen in Querrichtung taumelnden Scheiben wirken zudem wie lokal wirkende Rührer, die ein die Leiterplatte einseitig oder beidseitig umschließendes Behandlungsmedium lokal etwas bewegen und so eine gleichmäßige Behandlungswirkung fördern können.

Die in Fig. 1 gezeigten Transportwellen 2 bis 4 bilden eine Transportwellengruppe, deren Transportorgane 20 eine gemeinsame Transportebene tangieren, die parallel zur Zeichnungsebene verläuft. Die Transportorgane schaffen eine Vielzahl relativ dicht zueinander angeordneter Kontaktpunkte, die auch als Auflagepunkte bezeichnet werden können, wenn die Transportwellengruppe unterhalb einer beispielsweise horizontal transportierten Leiterplatte angeordnet ist und diese trägt. Die dichte Anordnung von Berührungs- bzw. Kontaktbereichen zwischen Transportorganen und Leiterplatte wird bei der Ausführungsform nach Fig. 1 und bei anderen Ausführungsformen dadurch gefördert, daß eine maximale radiale Ausdehnung der Transportorgane 20 größer ist als der halbe Abstand in Transportrichtung 1 aufeinanderfolgender Transportwellen zueinander. Dadurch wird erreicht, daß die Transportorgane 20 gegenseitig überlappen bzw. ineinander kämmen. Bei der Ausführungsform in Fig. 1 ist eine zweifache Versetzung in Transportrichtung aufeinanderfolgender Transportwellen realisiert, wobei jeweils die erste Transportwelle 2 und die identisch aufgebaute, zweite darauffolgende Transportwelle 4 nicht axial versetzt sind, während die mittig dazwischenliegende Transportwelle 3 in Axialrichtung um einen halben axialen Abstand benachbarter Transportorgane 20 einer Welle versetzt ist. Die Abstände zwischen den Taumelscheiben 20 sind zweckmäßig so gewählt, daß die Taumelscheiben benachbarter Wellen ohne Kollision in den Zwischenräumen ihre taumelnde Bewegung ausführen können.

Bei der Darstellung in Fig. 1 drehen alle Transportorgane gleichphasig, so daß deren Transportorgane gleichphasig sinusförmig oszillieren. Bei einer anderen, nicht gezeigten Ausführungsform ist die mittlere Transportwelle 3 gegenüber den benachbarten um 180° verdreht, so daß deren Transportorgane jeweils gegenläufig bzw. um 180° phasenversetzt zu den in Transportrichtung benachbarten Transportorganen oszillieren. Wenn Transportwellen derart ausgebildet und/oder angeordnet sind, daß die die Leiterplatte kontaktierenden Transportbereiche paarweise gegenläufig, insbesondere um 180° phasenversetzt oszillieren, dann ist dadurch zumindest teilweise eine Kompensation von Querkräften erreichbar, die eine Bewegung der Leiterplatte quer zur Transportrichtung verursachen könnten.

Bei der in Fig. 3 gezeigten Ausführungsform, deren unterhalb der Leiterplatte 30 liegende Transportwellengruppe und/oder die oberhalb der Leiterplatte liegende Transportwellengruppe so wie in Fig. 1 dargestellt ausgebildet sein können, ist der unteren Transportwelle 31 eine vertikal gegen diese versetzte obere Transportwelle 32 zugeordnet. Während die Transportorgane der unteren Transportwelle 31 die Unterseite der Leiterplatte kontaktieren und die Leiterplatte tragen, kontaktieren die Taumelscheiben der oberen Transportwelle die gegenüberliegende Plattenoberfläche. Bei beiden Transportwellen repräsentieren die durchgezogen gezeichneten Transportorgane eine erste Drehstellung und die gestrichelt gezeichneten Transportorgane eine zweite Drehstellung, die nach Drehung um 180° um die jeweilige Wellenachse erreicht wird. Diese Drehung bewirkt die Oszillation der Transportbereiche in Querrichtung 26. Während ausgehend von der gezeigten Situation die Transportbereiche der unteren Transportorgane sich in Richtung 33 nach links bewegen würden, wenn sich die Transportwelle 31 dreht, würden sich die Transportbereiche der Transportorgane der gegensinnig drehenden, oberen Transportwelle 32 in die entgegengesetzte Richtung 34 bewegen. Dies bewirkt eine zumindest teilweise Kompensation der auf die Leiterplatte ausgeübten Querkräfte, so daß diese richtungsgenau durch eine die gezeigte Transportvorrichtung aufweisende Behandlungsvorrichtung transportiert wird.

Anhand von Fig. 3 wird auch deutlich, daß die Transportbereiche 22 von dem zylindrischen inneren Bereich 14 der Transportwellen einen relativ großen radialen Abstand 35 haben bzw. daß die Transportorgane radial deutlich nach außen abstehen. Bei der gezeigten Ausführungsform ist der radiale Abstand 35 größer als der Radius des inneren Bereiches 14 und beträgt ca. das 1,5-fache dieses Radius (siehe auch Fig. 4d). Bei anderen Ausführungsformen kann das Verhältnis beispielsweise zwischen 1,1 und 4 liegen. Dadurch sind die zylindrischen Körper der Transportwellen relativ weit von der Leiterplatte entfernt, wodurch Behandlungsmedium im wesentlichen unbeeinflußt durch die tragenden Teile der Transportwelle an die Leiterplattenoberfläche gelangen kann.

## Patentansprüche

1. Leiterplatten-Transportvorrichtung zum Transportieren von Leiterplatten in einer Transportrichtung und in einer Transportebene, mit mindestens einer um eine Wellenachse drehbaren Transportwelle, der quer zur Wellenachse abstehende Transportorgane mit radial außenliegenden, in Abrollkontakt mit der Leiterplatte bringbaren Transportbereichen zugeordnet sind, die beim Transport die Leiterplatte entlang insbesondere streifenförmiger Kontaktbereiche kontaktieren, wobei die Transportvorrichtung derart ausgebildet ist, daß die Transportbereiche (22) in der Transportebene quer zur Transportrichtung (1) hin- und herbewegbar sind, **dadurch gekennzeichnet, daß** die Transportorgane (20) als elliptische Scheiben oder Ringe ausgebildet sind, die in einem Schrägungswinkel (21) zur Radialrichtung der Wellenachse (5) stehen und deren Projektion in Richtung der Wellenachse (5) im wesentlichen kreisförmig ist, daß eine maximale radiale Ausdehnung der Transportorgane (20) größer ist als der halbe Abstand in Transportrichtung (1) aufeinanderfolgender Transportwellen (2 bis 4; 31, 32) zueinander und daß die Abstände zwischen den ineinanderkämmenden Transportorganen (20) so gewählt sind, daß die Transportorgane (20) benachbarter Transportwellen kollisionsfrei laufen.

2. Leiterplatten-Transportvorrichtung nach Anspruch 1, **dadurch gekennzeichnet, daß** die Transportvorrichtung derart ausgebildet ist, daß eine in Querrichtung (26) gemessene Schwankungsbreite (27) der Transportbereiche (22) die Breite (24) der Transportbereiche (22) in Querrichtung (26) übersteigt.

3. Leiterplatten-Transportvorrichtung nach Anspruch 1 oder 2, **dadurch gekennzeichnet, daß** der Schrägungswinkel (21) den radialen Abmessungen der Transportorgane (20) derart angepaßt ist, daß eine in Querrichtung (26) gemessene Schwankungsbreite (27) der Transportbereiche (22) größer ist als die Breite (24) der Transportbereiche in Querrichtung, wobei der Schrägungswinkel (21) vorzugsweise zwischen 10 und 20° liegt, insbesondere bei ca. 15°.

4. Leiterplatten-Transportvorrichtung nach einem der vorhergehenden Ansprüche, **dadurch gekennzeichnet, daß** ein Verhältnis zwischen Breite (24) eines Transportbereiches (22) und Radius (23) des Transportorganes zwischen 0,2 und 0,5, insbesondere ca. 0,3, beträgt.

5. Leiterplatten-Transportvorrichtung nach einem der vorhergehenden Ansprüche, **dadurch gekennzeichnet, daß** die Transportorgane (20) einachsig gekrümmte Transportbereiche (22) haben, die im wesentlichen vollständig auf einer koaxial zur Wellenachse (5) liegenden Kreiszylinder-Mantelfläche liegen.

6. Leiterplatten-Transportvorrichtung nach einem der vorhergehenden Ansprüche, **dadurch gekennzeichnet, daß** die Transportorgane (20) Transportbereiche (22) haben, die in Umfangsrichtung mindestens abschnittsweise, vorzugsweise um den gesamten Umfang eines Transportorganes (20), eine im wesentlichen konstante Breite (24) haben.

7. Leiterplatten-Transportvorrichtung nach einem der vorhergehenden Ansprüche, **dadurch gekennzeichnet, daß** die Transportorgane (20) Transportbereiche (22) haben, die in Umfangsrichtung ununterbrochen sind.

8. Leiterplatten-Transportvorrichtung nach einem der vorhergehenden Ansprüche, **dadurch gekennzeichnet, daß** eine Transportwelle (2 bis 4; 31, 32) mehrere in vorzugsweise gleichen axialen Abständen versetzt zueinander angeordnete Transportorgane (20) aufweist, die bei Drehung der Transportwege vorzugsweise gleichphasig oszillieren.

9. Leiterplatten-Transportvorrichtung nach einem der vorhergehenden Ansprüche, **dadurch gekennzeichnet, daß** die Transportorgane (20) von in Transportrichtung (21) aufeinanderfolgenden Transportwegen (2 bis 4; 31, 32) quer zur Transportrichtung gegeneinander versetzt sind, wobei vorzugsweise eine zweite auf eine Transportwelle (2) folgende Transportwelle (4) eine identische Anordnung von Transportorganen (20) hat.

10. Leiterplatten-Transportvorrichtung nach einem der vorhergehenden Ansprüche, **dadurch gekennzeichnet, daß** die Transportwellen (2 bis 4; 31, 32) derart ausgebildet und/oder angeordnet sind, daß die Leiterplatte (30) kontaktierende Transportbereiche (22) paarweise gegenläufig, insbesondere um 180° phasenversetzt oszillieren.

11. Leiterplatten-Transportvorrichtung nach einem der vorhergehenden Ansprüche, **dadurch gekennzeichnet, daß** einer zur Kontaktierung einer Plattenoberfläche der Leiterplatte (30) vorgesehenen Transportwelle (31) mindestens eine zur Kontaktierung der gegenüberliegenden Plattenoberfläche vorgesehenen Transportwege (32) zugeordnet ist, deren Transportbereiche (22) vorzugsweise gegenläufig, insbesondere um 180° phasenversetzt oszillieren.

12. Leiterplatten-Transportvorrichtung nach einem der vorhergehenden Ansprüche, **dadurch gekennzeichnet, daß** die Transportorgane (20) einer Transportwelle (2 bis 4; 31, 32) an vorzugsweise nabenförmigen Bauelementen (6) angeordnet sind, die längs der Transportwelle, vorzugsweise einander berührend, aneinandergreiht, insbesondere auf einen Wellenkem (7) aufgesteckt sind, wobei vorzugsweise jedes Bauelement ein Transportorgan (20) aufweist.

13. Leiterplatten-Transportvorrichtung nach Anspruch 12, **dadurch gekennzeichnet, daß** an den Bauelementen (6) vorzugsweise stimseitig Eingriffsmittel (12, 13) für eine drehfeste Verbindung benachbarter Bauelemente vorgesehen sind, wobei die Eingriffsmittel (12, 13) vorzugsweise für die Anordnung der Transportorgane (20) mit definierter Orientierung entlang der Transportwelle (2 bis 4; 31, 32) ausgebildet sind.

14. Leiterplatten-Transportvorrichtung nach Anspruch 12 oder 13, **dadurch gekennzeichnet, daß** alle Bauelemente (6) einer Transportwelle (2 bis 4; 31, 32), vorzugsweise alle Bauelemente (6) einer Transportvorrichtung, identisch sind.

15. Leiterplatten-Transportvorrichtung nach einem der vorhergehenden Ansprüche, **dadurch gekennzeichnet, daß** die Transportorgane (20) mindetens im Bereich der Transportbereiche (22) aus weichem, insbesondere gummiartigem Material bestehen.

16. Leiterplatten-Transportvorrichtung nach einem der vorhergehenden Ansprüche, **dadurch gekennzeichnet, daß** die Transportbereiche (22) von einem vorzugsweise zylindrischen inneren Bereich (14) der Transportwelle (2 bis 4; 31, 32) einen radialen Abstand (35) haben, der größer als der Radius des inneren Bereiches (14) ist, wobei der Abstand vorzugsweise zwischen 1,1 und 4 mal, insbesondere ca. 1,5 mal so groß ist wie der Radius.

## Claims

1. Printed circuit board conveying device for conveying printed circuit boards in one conveying direction and in one conveying plane, with at least one conveying shaft rotatable about a shaft axis and with which are associated conveying members projecting at right angles to the shaft axis with radially outer conveying areas which can be brought into rolling contact with the printed circuit board and which during conveying contact the printed circuit board along in particular strip-like contact areas, the conveying device being constructed in such a way that the conveying areas (22) can be moved backwards and forwards in the conveying plane at right angles to the conveying direction (1), **characterized in that** the conveying members (20) are constructed as elliptical disks or rings, which are in a lead angle (21) to the radial direction of the shaft axis (5) and whose projection in the direction of the shaft axis (5) is substantially circular, that a maximum radial extension of the conveying members (20) is greater than half the spacing in the conveying direction (1) between successive conveying shafts (2 to 4; 31, 32) and that the spacings between the meshing conveying members (20) are selected in such a way that the conveying members (20) of adjacent conveying shafts run in collision-free manner.

2. Printed circuit board conveying device according to claim 1, **characterized in that** the conveying device is constructed in such a way that an extent of variation (27) of the conveying areas (22) measured in the transverse direction (26) exceeds the width (24) of the conveying areas (22) in the transverse direction (26).

3. Printed circuit board conveying device according to claim 1 or 2, **characterized in that** the lead angle (21) is so adapted to the radial dimensions of the conveying members (20) that an extent of variation (27) of the conveying areas (22) measured in the transverse direction (26) exceeds the width (24) of the conveying areas in the transverse direction, the lead angle (21) being preferably between 10 and 20ø and is in particular approximately 15ø.

4. Printed circuit board conveying device according to one of the preceding claims, **characterized in that** a ratio between the width (24) of a conveying area (22) and the radius (23) of the conveying member is between 0.2 and 0.5, being in particular approximately 0.3.

5. Printed circuit board conveying device according to one of the preceding claims, **characterized in that** the conveying members (20) have uniaxially curved conveying areas (22), which are substantially entirely located on a circular cylinder surface positioned coaxially to the shaft axis (5).

6. Printed circuit board conveying device according to one of the preceding claims, **characterized in that** the conveying members (20) have conveying areas (22), which have a substantially constant width (24) at least zonally in the circumferential direction and preferably around the entire circumference of a conveying member (20).

7. Printed circuit board conveying device according to one of the preceding claims, **characterized in that** the conveying members (20) have conveying members (22) which are circumferentially uninterrupted.

8. Printed circuit board conveying device according to one of the preceding claims, **characterized in that** a conveying shaft (2 to 4; 31, 32) has several conveying members (20) which are mutually displaced with preferably equal axial spacings and which during the rotation of the conveying shaft preferably oscillate in in-phase manner.

9. Printed circuit board conveying device according to one of the preceding claims, **characterized in that** the conveying members (20) of successive conveying shafts (2 to 4; 31, 32) in the conveying direction (21) are staggered at right angles to the conveying direction and preferably a second conveying shaft (4) following onto a conveying shaft (2) has an identical arrangement of the conveying members (20).

10. Printed circuit board conveying device according to one of the preceding claims, **characterized in that** the conveying shafts (2 to 4; 31, 32) are so constructed and/or arranged that conveying areas (22) contacting the printed circuit board (30) pairwise contrarotate and in particular oscillate in particular phase-displaced by 180ø.

11. Printed circuit board conveying device according to one of the preceding claims, **characterized in that** a conveying shaft (31) provided for contacting a board surface of the printed circuit board (30) has associated with it a conveying shaft (32) for contacting the facing board surface and whereof the conveying areas (22) preferably contrarotate and in particular oscillate in phase-displaced manner by 180ø.

12. Printed circuit board conveying device according to one of the preceding claims, **characterized in that** the conveying members (20) of a conveying shaft (2 to 4; 31, 32) are located on preferably hub-like components (6), which are lined up along the conveying shaft and preferably in contact with one another and are in particular mounted on a shaft core (7) and preferably each component has a conveying member (20).

13. Printed circuit board conveying device according to claim 12, **characterized in that** on the components (6) are provided preferably frontal engagement means (12, 13) so as to connect to rotate adjacent components, the engagement means (12, 13) preferably being constructed for the arrangement of the conveying members (20) with a clearly defined orientation along the conveying shaft (2 to 4; 31, 32).

14. Printed circuit board conveying device according to claim 12 or 13, **characterized in that** all the components (6) of a conveying shaft (2 to 4; 31, 32) and preferably all the components (6) of a conveying device are identical.

15. Printed circuit board conveying device according to one of the preceding claims, **characterized in that** the conveying members (20), at least in the vicinity of the conveying areas (22), are made from soft, particularly rubbery material.

16. Printed circuit board conveying device according to one of the preceding claims, **characterized in that** the conveying areas (22) have a radial spacing (35) from a preferably cylindrical, inner area (14) of the conveying shaft (2 to 4; 31, 32) which is greater than the radius of the inner area (14), the spacing preferably being between 1.1 and 4 times, particularly approximately 1.5 times as large as the radius.

## Revendications

1. Dispositif de transport de plaquettes de circuits imprimés pour transporter des plaquettes dans un sens et un plan de transport, avec au moins un arbre transporteur pouvant tourner autour d'un axe d'arbre, conjugué à des organes de transport s'étendant transversalement par rapport à l'axe d'arbre avec des zones de transport radiales extérieures pouvant être mises en contact par roulement avec les plaquettes, qui, lors du transport, entrent en contact avec les plaquettes le long de zones de contact ayant en particulier la forme de bandes, le dispositif de transport étant formé de sorte que, dans le plan de transport, les zones de transport (22) peuvent être déplacées dans un mouvement de va-et-vient transversalement par rapport au sens de transport (1), **caractérisé en ce que** les organes de transport (20) sont formés par des disques ou des anneaux elliptiques placés selon une angle d'inclinaison (21) par rapport au sens radial de l'axe d'arbre (5), et dont la projection en direction de l'axe d'arbre (5) est essentiellement circulaire, qu'une extension radiale maximale des organes de transport (20) est plus grande que la moitié de la distance dans le sens de transport (1) de deux arbres transporteurs successifs (2 à 4 ; 31, 32), et que les distances entre les organes de transport (20) s'imbriquant sont choisies de sorte que les organes de transport (20) des arbres transporteurs voisins se déplacent sans collision.

2. Dispositif de transport de plaquettes de circuits imprimés selon la revendication 1, **caractérisé en ce que** le dispositif de transport est formé de sorte qu'une largeur d'oscillation (27) des zones de transport (22) mesurée sans le sens transversal (26) est supérieure à la largeur (24) des zones de transport (22) dans le sens transversal (26).

3. Dispositif de transport de plaquettes de circuits imprimés selon la revendication 1 ou 2, **caractérisé en ce que** l'angle d'inclinaison (21) est adapté aux dimensions radiales des organes de transport (20) de sorte qu'une largeur d'oscillation (27) des zones de transport (22) mesurée dans le sens transversal (26) est supérieure à la largeur (24) des zones de transport sans le sens transversal, la valeur de l'angle d'inclinaison (21) se situant de préférence entre 10 et 20°, en particulier à 15° environ.

4. Dispositif de transport de plaquettes de circuits imprimés selon l'une des revendications précédentes, **caractérisé en ce qu'**un rapport entre la largeur (24) d'une zone de transport (22) et le rayon (23) de l'organe de transport se situe entre 0,2 et 0,5, en particulier à 0,3 environ.

5. Dispositif de transport de plaquettes de circuits imprimés selon l'une des revendications précédentes, **caractérisé en ce que** les organes de transport (20) présentent des zones de transport (22) curvilignes monoaxiales qui, pour l'essentiel, s'appuient sur une surface enveloppante cylindrique circulaire coaxiale par rapport à l'axe d'arbre (5).

6. Dispositif de transport de plaquettes de circuits imprimés selon l'une des revendications précédentes, **caractérisé en ce que** les organes de transport (20) présentent des zones de transport (22) qui, dans le sens périphérique, au moins en partie, de préférence sur toute la périphérie d'un organe de transport (20), ont une largeur (24) essentiellement constante.

7. Dispositif de transport de plaquettes de circuits imprimés selon l'une des revendications précédentes, **caractérisé en ce que** les organes de transport (20) présentent des zones de transport (22) ininterrompues dans le sens périphérique.

8. Dispositif de transport de plaquettes de circuits imprimés selon l'une des revendications précédentes, **caractérisé en ce qu'**un arbre transporteur (2 à 4 ; 31, 32) présente plusieurs organes de transport (20) décalés les uns par rapport aux autres de préférence selon des distances axiales identiques, qui oscillent de préférence en phase lorsque l'arbre transporteur tourne.

9. Dispositif de transport de plaquettes de circuits imprimés selon l'une des revendications précédentes, **caractérisé en ce que** les organes de transport (20) des arbres transporteurs (2 à 4 ; 31, 32) successifs sont décalés les uns par rapport aux autres transversalement au sens de transport (21), un deuxième arbre transporteur (4) succédant à un arbre transporteur (2) présentant un agencement identique d'organes de transport (20).

10. Dispositif de transport de plaquettes de circuits imprimés selon l'une des revendications précédentes, **caractérisé en ce que** les arbres transporteurs (2 à 4 ; 31, 32) sont formés et/ou agencés de manière à ce que les zones de transport (22) en contact avec les plaquettes (30) oscillent par paires en sens contraires, en particulier selon un déphasage de 180°.

11. Dispositif de transport de plaquettes de circuits imprimés selon l'une des revendications précédentes, **caractérisé en ce qu'**un arbre transporteur (31) prévu pour prendre contact avec une surface de la plaquette (30) est conjugué avec au moins un arbre transporteur (32) prévu pour prendre contact avec la surface opposée de la plaquette, dont les zones de transport (22) oscillent en sens contraires, en particulier selon un déphasage de 180°.

12. Dispositif de transport de plaquettes de circuits imprimés selon l'une des revendications précédentes, **caractérisé en ce que** les organes de transport (20) d'un arbre transporteur (2 à 4 ; 31, 32) sont disposés sur des éléments porteurs (6) de préférence en forme de moyeu qui, le long de l'arbre transporteur, sont introduits les uns derrière les autres, de préférence en se touchant, en particulier sur une âme d'arbre (7), chaque élément porteur présentant de préférence un organe de transport (20).

13. Dispositif de transport de plaquettes de circuits imprimés selon la revendication 12, **caractérisé en ce que** sur les éléments porteurs (6) sont prévus des moyens d'engrènement (12, 13) de préférence à l'avant pour assurer une liaison sans torsion avec l'élément porteur voisin, les moyens d'engrènement (12, 13) étant de préférence formés pour l'agencement des organes de transport (20) le long de l'arbre transporteur (2 à 4 ; 31, 32) avec une orientation définie.

14. Dispositif de transport de plaquettes de circuits imprimés selon la revendication 12 ou 13, **caractérisé en ce que** tous les éléments porteurs (6) d'un arbre transporteur (2 à 4 ; 31, 32), de préférence tous les éléments porteurs (6) d'un dispositif de transport, sont identiques.

15. Dispositif de transport de plaquettes de circuits imprimés selon l'une des revendications précédentes, **caractérisé en ce que** les organes de transport (20), au moins dans la zone des zones de transport (22), sont constitués d'un matière souple, en particulier caoutchouteuse.

16. Dispositif de transport de plaquettes de circuits imprimés selon l'une des revendications précédentes, **caractérisé en ce que** les zones de transport (22) sont à une distance radiale (35) d'une zone interne (14) de préférence cylindrique de l'arbre transporteur (2 à 4 ; 31, 32) qui est supérieure au rayon de la zone interne (14), la distance étant de préférence entre 1,1 et 4 fois, en particulier 1,5 fois supérieure au rayon.
